# EUROPÄISCHE PATENTSCHRIFT

(11) **EP 3 200 033 B1**
(45) Veröffentlichungstag und Bekanntmachung des Hinweises auf die Patenterteilung: **10.07.2019**
(21) Anmeldenummer: 16153428.4
(22) Anmeldetag: 29.01.2016
(51) Int. Cl.: G05B 19/042, G01R 1/20, G01R 27/16

(54) **ANORDNUNG MIT ZUMINDEST ZWEI PERIPHERIE-EINHEITEN UND MIT EINEM SENSOR**
ASSEMBLY COMPRISING AT LEAST TWO PERIPHERAL UNITS WITH A SENSOR
SYSTEME COMPRENANT AU MOINS DEUX UNITES PERIPHERIQUES ET UN CAPTEUR

(43) Veröffentlichungstag der Anmeldung: 02.08.2017
(73) Patentinhaber: Siemens Aktiengesellschaft, 80333 München (DE)
(72) Erfinder: Maier, Willi, 77728 Oppenau (DE); Rottmann, Norbert, 76829 Landau (DE)

(56) Entgegenhaltungen:
- EP-A1- 2 806 316
- DE-A1- 10 358 989

## Beschreibung

Die Erfindung betrifft eine Anordnung mit zumindest zwei Peripherie-Einheiten und mit einem Sensor, wobei jede der Peripherie-Einheiten versehen ist mit einem Anschluss zum Anschließen des Sensors an eine Versorgungsspannung, mit einem Sensoreingang zum Anschließen des Sensors und ferner mit einem Messwiderstand zum Erfassen eines einen Signalzustand repräsentierenden Sensorstroms. Darüber hinaus betrifft die Erfindung eine Peripherie-Einheit gemäß dem Oberbegriff des Anspruchs 5, welche für eine derartige Anordnung geeignet ist. Im Automatisierungsumfeld werden verstärkt hochverfügbare Lösungen (H-Systeme) gefordert, welche geeignet sind, eventuell auftretende Stillstandszeiten der Anlage auf ein Minimum zu reduzieren. Diese H-Systeme weisen gewöhnlich zwei mehrere Baugruppen aufweisende Automatisierungsgeräte bzw. speicherprogrammierbare Steuerungen (Progammable Logic Controllers) auf, wobei auf die an die Automatisierungsgeräte angeschlossenen, mit mehreren Peripheriebaugruppen versehenen Peripherieeinheiten bzw. dezentralen Peripherien beide Automatisierungsgeräte lesend und/oder schreibend zugreifen können. Damit beide Automatisierungsgeräte synchron ablaufen können, werden diese in regelmäßigen Abständen synchronisiert. Ferner ist es in hochverfügbaren Systemen häufig auch erwünscht, zwei Peripheriebaugruppen einer dezentralen Peripherie oder zwei Peripheriebaugruppen von zwei derartigen dezentralen Peripherien redundant zu betreiben. Für den Fall, dass diese Peripherie-Baugruppen als Digitaleingabe-Baugruppen ausgebildet sind, ist ein (einzelner) Sensor üblicherweise an beide (Partner-)Peripheriebaugruppen angeschlossen, wobei die dezentralen Peripherien über einen Bus mit einem mehrere Baugruppen aufweisenden Automatisierungsgerät in Form eines Zentral- oder Erweiterungsgeräts verbunden sind. Für den Fall allerdings, dass der Sensor als ein in der Prozessautomatisierung weit verbreiteter so genannter NAMUR-Sensor entsprechend DIN 19234 ausgebildet ist, ist es nicht ohne weiteres möglich, diesen (einzelnen) NAMUR-Sensor an zwei Digitaleingabe-Baugruppe gleichzeitig zu betreiben, weil sich in diesem Fall aufgrund des vom NAMUR-Sensor gelieferten eingeprägten Stromes unstimmige Signalzustände ergeben würden.

Beispielsweise beaufschlagt eine aus dem Siemens-Gerätehandbuch "Dezentrale Peripherie ET 200S, Digitales Elektronikmodul 4DI NAMUR", Ausgabe 3/2010 bekannte, als Digitaleingabe-Baugruppe ausgebildete Peripherie-Einheit, einen angeschlossenen NAMUR-Sensor mit einer Versorgungsspannung von 8,2 V, wobei mittels vom Sensor eingeprägter Ströme unterschiedliche Signalzustände "0", "1", "Drahtbruch" oder "Kurzschluss" abgebildet werden. Ein Strom kleiner als 0,35 mA repräsentiert einen Drahtbruch zwischen NAMUR-Sensor und Digitaleingabe-Baugruppe, ein Strom von 0,35 mA bis 1,2 mA einen Signalzustand "0", ein Strom von 2,1 mA bis 7 mA einen Signalzustand "1" und ein Strom größer als 7 mA einen kurzgeschlossenen NAMUR-Sensor. Der Strom fließt über einen niederohmigen Messwiderstand (Shunt) der Digitaleingabe-Baugruppe und bewirkt an diesem Messwiderstand (1 kOhm) einen zu diesem eingeprägten Strom proportionalen Spannungsabfall, welcher baugruppenintern den Signalzustand des NAMUR-Sensors abbildet bzw. repräsentiert.

Für den Fall, dass der NAMUR-Sensor der Digitaleingabe-Baugruppe beispielsweise einen Strom von 2,4 mA einprägt, fällt am Messwiderstand eine Spannung von 2,4 V ab, wobei dieser Spannungsabfall von der Digitaleingabe-Baugruppe als Signalzustand "1" interpretiert wird.
Für den Fall dagegen, dass der NAMUR-Sensor gleichzeitig an zwei derartigen Digitaleingabe-Baugruppen angeschlossen und betrieben wird, d. h. dass der Sensor jeweils an einem Eingang dieser Digitaleingabe-Baugruppen angeschlossen wird, sind die Messwiderstände der Baugruppen parallelgeschaltet, wodurch sich der vom NAMUR-Sensor eingeprägte Strom von beispielsweise 2,4 mA proportional aufteilt und daher an jedem der beiden Messwiderstände der beiden Baugruppen nur 1,2 V abfällt. Dieser Spannungsabfall von 1,2 V wird von den Digitaleingabe-Baugruppen als Signalzustand "0" bewertet, was bedeutet, dass ein falscher Signalzustand "detektiert" wurde.

Um bei einem redundantem Betrieb einen eindeutigen Signalzustand bilden zu können, ist es daher zwingend erforderlich, dass jede der beiden Digitaleingabe-Baugruppen zu jedem Zeitpunkt die Verfügbarkeit seiner Partnerbaugruppe kennen muss um die erfasste Spannung korrekt zu bewerten. Um dies zu bewerkstelligen kann daher für jede Digitaleingabe-Baugruppe bzw. Digitaleingabe-Einheit ein NAMUR-Sensor vorgesehen werden, um die Hochverfügbarkeit von NAMUR-Sensoren sicherzustellen.

Aus der DE 103 58 989 A1 ist ein redundantes Steuersystem mit einem ersten und einem zweiten Steuerrechner bekannt, an welche jeweils eine Peripherieeinheit anschließbar ist.

EP 2 806 316 A1 offenbart ein Automatisierungssystem mit einem Automatisierungsgerät und einem dezentralen Peripheriesystem, das mindestens zwei Peripheriebaugruppen aufweist, die in einem mehrere Peripheriebaugruppen aufweisenden Peripheriegerät oder jeweils in einem von zwei derartigen Peripheriegeräten angeordnet sind.

Der Erfindung liegt daher die Aufgabe zugrunde, eine Anordnung der eingangs genannten Art zu schaffen, welche eine redundante Erfassung und Auswertung des Signalzustands des Sensorsignals bzw. welche einen redundanten Betrieb des Sensors an den zumindest zwei Peripherie-Einheiten ermöglicht. Darüber hinaus ist eine Peripherie-Einheit gemäß dem Oberbegriff des Anspruchs 4 anzugeben, die für eine derartige Anordnung geeignet ist.

Diese Aufgabe wird im Hinblick auf die Anordnung durch die im kennzeichenenden Teil des Anspruchs 1 angegebenen, bezüglich der Peripherie-Einheit durch die im kennzeichnenden Teil des Anspruchs 4 angegebenen Maßnahmen gelöst.

Vorteilhaft ist, dass z. B. für den Fall, dass die Peripherie-Einheiten als Digitaleingabe-Einheiten ausgebildet sind, für eine redundante Erfassung und Auswertung z. B. von NAMUR-Signalen nicht für jede der Digitaleingabe-Einheiten ein NAMUR-Sensor vorgesehen werden muss. Es ist lediglich ein NAMUR-Sensor an den jeweiligen NAMUR-Eingang der Digitaleingabe-Einheiten anzuschließen. Der Sensoreingang einer der Digitaleingabe-Einheiten ist hochohmig und der Sensoreingang der anderen Digitaleingabe-Einheit niederohmig geschaltet, wodurch der Sensorstrom nahezu vollständig über den Messwiderstand der niederohmig geschalteten Digitaleingabe-Einheit fließt. An beiden Sensoreingängen wird - gleiche Sensor-Versorgungsspannung vorausgesetzt - der gleiche Spannungsabfall erfasst, sodass beide Digitaleingabe-Einheiten in der Lage sind den gleichen Signalzustand zu detektieren und über den Stromfluss z. B. einen Fehler in Form eines Drahtbruchs zu erkennen. Es wird sichergestellt, dass für den Fall, dass eine der Digitaleingabe-Einheiten ausfällt oder eine dieser Digitaleingabe-Einheiten aus der Steuerung entfernt wird ("ziehen" der Digitaleingabe-Einheit), zu jeder Zeit für die andere Digitaleingabe-Einheit das NAMUR-Signal der Signalzustand des NAMUR-Sensors verfügbar ist. Um dies bei Ausfall der niederohmig geschalteten Digitaleingabe-Einheit zu ermöglichen, ist jede der Digitaleingabe-Einheiten dazu ausgebildet, das Umschaltsignal selbst zu erzeugen oder zu empfangen. Im Falle eines Komplettausfalls einer der Digitaleingabe-Einheiten erzeugt die andere Digitaleingabe-Einheit das Umschaltsignal selbst. Für den Fall, dass eine der Digitaleingabe-Einheiten das Sensorsignal nicht erfassen kann (Drahtbruch), empfängt die andere Digitaleingabe-Einheit das Umschaltsignal von der einen Digitaleingabe-Einheit.

Jede der Digitaleingabe-Einheiten ist ferner dazu ausgebildet ist, ein weiteres Umschaltsignal von einer Steuerung zu empfangen. Dadurch ist sichergestellt, dass die Steuerung z. B. zum Einstellen eines Grundzustands eine der Digitaleingabe-Einheiten als Master-Einheit und die andere als Slave-Einheit definiert bzw. parametriert. Dabei ist der Begriff "Steuerung" für den Gesamtzusammenhang dieser Beschreibung so auszulegen, dass er sämtliche Geräte, Einrichtungen oder Systeme umfasst, also neben z. B. Steuerungen, wie speicherprogrammierbaren Steuerungen, Automatisierungsgeräten, dezentrale Peripherien, Prozessrechnern, (Industrie-)Computern und dergleichen, auch Antriebssteuerungen und Ähnliches, wie sie zur Steuerung, Regelung und/oder Überwachung technischer Prozesse geeignet sind.

In einer Ausgestaltung der Erfindung ist die Umschalteinrichtung dazu ausgebildet, mittels eines Schalters einen überbrückbaren hochohmigen Widerstand dem Messwiderstand in Reihe zu schalten oder den niederohmigen Messwiderstand einem hochohmigen Widerstand parallelzuschalten. Dadurch kann mit einfachen schaltungstechnischen Mitteln eine Umschaltung von nieder- auf hochohmig sowie von hoch- auf niederohmig bewerkstelligt werden.

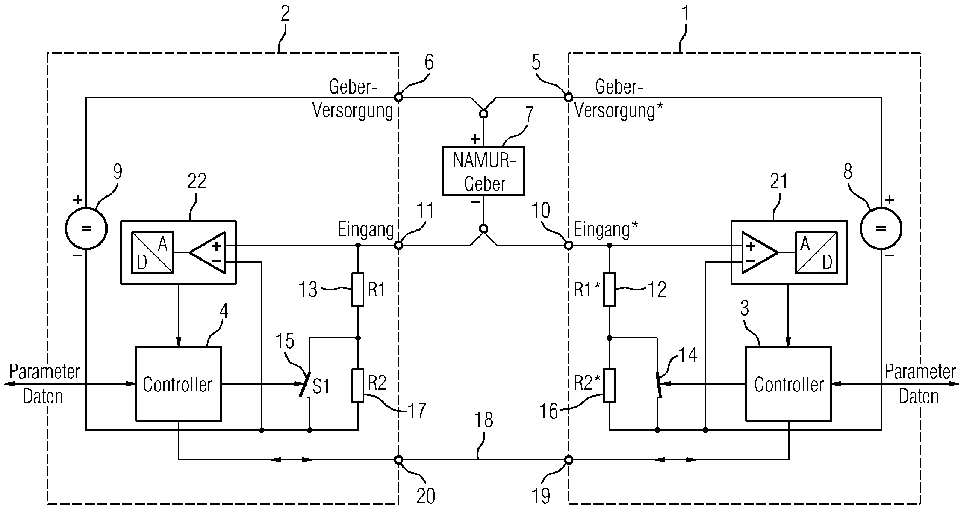

Die Erfindung, deren Ausgestaltungen sowie deren Vorteile werden nachfolgend anhand eines Ausführungsbeispiels unter Bezugnahme auf die einzige Figur der Zeichnung näher erläutert. Die Figur der Zeichnung zeigt in vereinfachter Darstellung eine Anordnung mit zwei Digitaleingabe-Einheiten zur redundanten Erfassung und Auswertung eines NAMUR-Signals.

Die Anordnung weist zwei Digitaleingabe-Einheiten 1, 2 auf, von denen im vorliegenden Ausführungsbeispiel die Digitaleingabe-Einheit 1 als Master-Einheit und die Digitaleingabe-Einheit 2 als Slave-Einheit voreingestellt ist. Diese Voreinstellung wird durch eine hier nicht dargestellte Steuerung vorgegeben, die jeweils einem Controller 3, 4 der Digitaleingabe-Einheiten 1, 2 entsprechende Parameter zum Einstellen eines Master- oder Slave-Grundzustandes übermittelt. Die Steuerung kann als CPU-Einheit einer speicherprogrammierbaren Steuerung oder als CPU-Einheit einer mehrere Einheiten bzw. Baugruppen aufweisenden dezentralen Peripherie ausgebildet sein, die über eine Busverbindung Informationen mit der speicherprogrammierbaren Steuerung austauscht. Die Digitaleingabe-Einheiten 1, 2, an welche der Sensor 7 gleichzeitig geschlossen ist, können selbstverständlich Einheiten dieser dezentralen Peripherie oder dieser speicherprogrammierbaren Steuerung sein.

Zur besseren Übersicht und der Einfachheit halber ist im vorliegenden Beispiel nur ein Kanal der Digitaleingabe-Einheiten 1, 2 dargestellt. Gewöhnlich weisen die Digitaleingabe-Einheiten 1, 2 eine Vielzahl von Kanälen auf, wobei an jedem Kanal ein NAMUR- oder ein sonstiger Sensor anschließbar ist. Jede dieser Digitaleingabe-Einheiten 1, 2 weist einen Anschluss 5, 6 zum Anschließen eines NAMUR-Sensors 7 an eine Versorgungsspannung von beispielsweise 8,2 V auf, wobei Gleichspannungsquellen 8, 9 der Digitaleingabe-Einheiten 1, 2 den NAMUR-Sensor 7 mit dieser Versorgungsspannung beaufschlagen. Ferner ist jede der Digitaleingabe-Einheiten 1, 2 mit einem Sensoreingang 10, 11 zum Anschließen des NAMUR-Sensors 7 und mit einem niederohmigen Messwiderstand 12, 13 zum Erfassen eines einen Signalzustand repräsentierenden Sensorstroms versehen, welcher der NAMUR-Sensor 7 den Digitaleingabe-Einheiten 1, 2 über die Sensoreingänge 10, 11 einprägt. Beide Digitaleingabe-Einheiten 1, 2 weisen darüber hinaus jeweils eine Umschalteinrichtung auf, die es ermöglicht, den jeweiligen Eingang 10, 11 hochohmig zu schalten. Im vorliegenden Beispiel ist dazu jeweils ein in Serie zu dem jeweiligen Messwiderstand 12, 13 geschalteter steuerbarer Schalter 14, 15 und ein dazu parallelgeschalteter hochohmiger Widerstand 16, 17 vorgesehen. Die Widerstände sind in einem praktischen Ausführungsbeispiel der Erfindung so dimensioniert, dass der Widerstandswert der jeweiligen hochohmigen Widerstände 16, 17 das 100-fache des Widerstandswerts des jeweiligen Messwiderstandes 12, 13 beträgt. Für den Fall, dass beispielsweise 1 kOhm-Messwiderstände eingesetzt werden, sind daher 100 kOhm-Widerstände für die Umschalteinrichtungen vorzusehen. Die Umschalteinrichtung kann auch in der Art und Weise verwirklicht werden, dass parallel zu einem hochohmigen Widerstand (z. B. 100 kOhm) ein über einen steuerbaren Schalter zuschaltbarer niederohmiger Widerstand angeordnet wird.

Die Ansteuerung der Schalter 14, 15 erfolgt jeweils in Abhängigkeit eines über eine Kommunikationsleitung 18 geführten Umschalt- bzw. Steuersignals oder in Abhängigkeit eines weiteren Umschalt- bzw. Steuersignals zur Voreinstellung der jeweiligen Digitaleingabe-Einheit als Master- oder Slave-Einheit. Beispielsweise zeigt während der Erfassung des Sensorstroms die Digitaleingabe-Einheit 1 der Digitaleingabe-Einheit 2 über das vom Controller 3 erzeugte Steuersignal seinen aktuellen Zustand (Master-Zustand) an. Mittels dieses Informationsaustausches über die Kommunikationsleitung 18, die Anschlüsse 19, 20 der Digitaleingabe-Einheiten 1, 2 verbindet, kennt jede Digitaleingabe-Einheit 1, 2 den Zustand der jeweils anderen Digitaleingabe-Einheit 1, 2.

Im Folgenden wird auf die Funktions- und Wirkungsweise der Anordnung näher eingegangen. Dabei ist - wie erläutert - die Digitaleingabe-Einheit 1 als Master-Einheit und die Digitaleingabe-Einheit 2 als Slave-Einheit voreingestellt, wobei zu dieser Einstellung die jeweiligen Controller 3, 4 aufgrund der von der Steuerung übermittelten Parameter jeweils ein Steuersignal zum Ansteuern der Schalter 14, 15 erzeugen. Um die Digitaleingabe-Einheit 1 als Master-Einheit voreinzustellen, erzeugt der Controller 3 ein Steuersignal zum Schließen des Schalters 14. Dagegen erzeugt der Controller 4 ein Steuersignal zum Öffnen des Schalters 15, wodurch die Digitaleingabe-Einheit 2 die Slave-Funktion übernimmt.

Diese voreingestellten Schalterstellungen der Schalter 14, 15 bewirken, dass einerseits der hochohmige Widerstand 17 mit dem niederohmigen Messwiderstand 13 der Slave-Einheit 2 in Reihe geschaltet und anderseits der hochohmige Widerstand 16 der Master-Einheit 1 überbrückt ist, was bedeutet, dass der Sensorstrom nahezu vollständig über den niederohmigen Messwiderstand 12 der Master-Einheit 1 der Digitaleingabe-Einheit 1 fließt. An beiden Sensoreingängen 10, 11 wird der gleiche Spannungsabfall erfasst, so dass sowohl beide Digitaleingabe-Einheiten 1, 2 den gleichen Signalzustand (intern) detektieren.

Ausgehend von den voreingestellten Schalterstellungen, welche die Digitaleingabe-Einheit 1 als Master-Einheit und die Digitaleingabe-Einheit 2 als Slave-Einheit definieren bzw. einstellen, werden im Hinblick auf die Anordnung mit dem gleichzeitig an die Digitaleingabe-Einheiten 1, 2 angeschlossenen NAMUR-Sensor 7 folgende Szenarien erläutert:
A) Entfernen der Slave-Einheit (Digitaleingabe-Einheit 2):
   Die Digitaleingabe-Einheit 1 (Master-Einheit) erfasst nach wie vor den Stromfluss, ermittelt den Signalzustand und übermittelt diesen der Steuerung. Die Steuerung erkennt aufgrund eines fehlenden Signals des Controllers 4, dass die Slave-Einheit nicht mehr in der Anordnung vorhanden ist.
B) Entfernen der Master-Einheit (Digitaleingabe-Einheit 1):
   Dadurch dass die Kommunikationsleitung 18 aufgrund der fehlenden Master-Einheit unterbrochen wird, wird mittels des Controllers 4 der Schalter 15 der Digitaleinheit 2 geschlossen. Die Digitaleingabe-Einheit 2 übernimmt daher den Stromfluss und wird somit zur Master-Einheit. Nun ermittelt die Digitaleingabe-Einheit 2 den Signalzustand und übermittelt diesen der Steuerung. Die Steuerung erkennt aufgrund eines fehlenden Signals des Controllers 3, dass die Digitaleingabe-Einheit 1 nicht mehr in der Anordnung vorhanden ist.
C) Drahtbruch zwischen der Slave-Einheit (Digitaleingabe-Einheit 2) und dem NAMUR-Sensor 7:
   Die Digitaleingabe-Einheit 2 erkennt den Drahtbruch dadurch, dass die Digitaleingabe-Einheit 2 keine Spannung am Eingang 11 misst, was entsprechend der NAMUR-Definition ein ungültiges Signal bedeutet. Dieser Zustand wird über eine geeignete Diagnoseinformation zur Steuerung übermittelt. Die Master-Einheit (Digitaleingabe-Einheit 1) liefert weiterhin den gültigen Signalzustand bzw. den gültigen Status.
D) Drahtbruch zwischen der Master-Einheit (Digitaleingabe-Einheit 1) und dem NAMUR-Sensor 7:
   Die Digitaleingabe-Einheit 1 erkennt den Drahtbruch anhand des ausbleibenden Stromflusses und übermittelt über die Kommunikationsleitung 18 ein Umschaltsignal, z. B. derart, dass die Digitaleingabe-Einheit 1 die Kommunikationsleitung 18 "stromlos schaltet". Der Controller 4 der Digitaleingabe-Einheit 2 schließt daraufhin den Schalter 15, wodurch die Digitaleingabe-Einheit 2 die Master-Funktion übernimmt und den Signalzustand des NAMUR-Sensors 7 der Steuerung übermittelt. Die Digitaleingabe-Einheit 1 (bisherige Master-Einheit) meldet der Steuerung den Drahtbruch mittels einer geeigneten Diagnosemeldung bzw. Diagnoseinformation.
E) Drahtbruch im NAMUR-Sensor 7 oder zwischen den Anschlüssen 5, 6 und dem NAMUR-Sensor 7:
   Beide Digitaleingabe-Einheiten 1, 2 erkennen gleichzeitig den Drahtbruch (kein Stromfluss), wobei die Master-Einheit oder beide Digitaleingabe-Einheiten 1, 2 der Steuerung über eine geeignete Diagnoseinformation einen Ausfall des NAMUR-Sensors 7 melden.
F) Kurzschluss des NAMUR-Sensors 7:
   Der Kurzschlussstrom (>7mA) fließt fast vollständig über den Messwiderstand 12 der Digitaleingabe-Einheit 1 (Master-Einheit); an den Eingängen 10, 11 der Digitaleingabe-Einheiten 1, 2 wird der gleiche Spannungsabfall erfasst, so dass beide Digitaleingabe-Einheiten 1, 2 den gleichen Signalzustand (Kurzschluss des NAMUR-Sensors 7) detektieren. Dieser detektierte Signalzustand wird der Steuerung mittels des Controllers 3 der Digitaleingabe-Einheit 1 (Master-Einheit) übermittelt.

## Patentansprüche

1. Anordnung mit zumindest zwei Peripherie-Einheiten (1, 2) und mit einem Sensor (7), wobei jede der Peripherie-Einheiten (1, 2) versehen ist mit
- einem Anschluss (5, 6) zum Anschluss des Sensors (7) an eine Versorgungsspannung,
- einem Sensoreingang (10, 11) zum Anschließen des Sensors (7),
- einem Messwiderstand (12, 13) zum Erfassen eines einen Signalzustand repräsentierenden Sensorstroms und
- einer Umschalteinrichtung (14, 16; 15, 17), die dazu ausgebildet ist, in Abhängigkeit eines Umschaltsignals oder eines weiteren Umschaltsignals den Sensoreingang (10, 11) nieder- oder hochohmig zu schalten,
**dadurch gekennzeichnet, dass**
- die Peripherie-Einheiten (1, 2) mittels einer Kommunikationsleitung (18) miteinander verbunden sind,
- jede der Peripherie-Einheiten dazu ausgebildet ist,
- das Umschaltsignal zu erzeugen oder über die Kommunikationsleitung (18) von der anderen Peripherie-Einheit (1, 2) zu empfangen und
- das weitere Umschaltsignal von einer Steuerung zur Voreinstellung der jeweiligen Peripherie-Einheit (1, 2) als eine Master- oder als eine Slave-Einheit zu empfangen, wobei der Sensoreingang (10) der Master-Einheit (1) niederohmig und der Sensoreingang (11) der Slave-Einheit (2) hochohmig geschaltet ist.

2. Anordnung nach Anspruch 1, **dadurch gekennzeichnet, dass** die Umschalteinrichtung (14, 16; 15, 17) dazu ausgebildet ist, mittels eines Schalters (14, 15) einen überbrückbaren hochohmigen Widerstand (16, 17) dem Messwiderstand (13, 14) in Reihe zu schalten oder den niederohmigen Messwiderstand (13, 14) einem hochohmigen Widerstand parallelzuschalten.

3. Anordnung nach Anspruch 1 oder 2, **dadurch gekennzeichnet, dass** eine der Peripherie-Einheiten (1, 2) hochohmig geschaltet ist, falls die andere Peripherie-Einheit (1, 2) niederohmig geschaltet ist.

4. Peripherie-Einheit für eine Anordnung nach einem der Ansprüche 1 bis 3, mit
- einem Anschluss zum Anschließen eines Sensors (7) an eine Versorgungsspannung,
- einem Sensoreingang (10, 11) zum Anschließen des Sensors (7),
- einem Messwiderstand (12, 13) zum Erfassen eines einen Signalzustand repräsentierenden Sensorstroms und
- einer in Serie zum Messwiderstand (12, 13) geschalteten Umschalteinrichtung, die dazu ausgebildet ist, in Abhängigkeit eines Umschaltsignals oder eines weiteren Umschaltsignals den Sensoreingang (10, 11) nieder- oder hochohmig zu schalten,
**dadurch gekennzeichnet, dass**
- die Peripherie-Einheit (1, 2) einen Anschluss (19, 20) zum Verbinden mit einer anderen Peripherie-Einheit über eine Kommunikationsleitung (18) aufweist,
- die Peripherie-Einheit (1, 2) dazu ausgebildet ist,
- das Umschaltsignal zu erzeugen oder über die Kommunikationsleitung (18) von der anderen Peripherie-Einheit (1, 2) zu empfangen und
- das weitere Umschaltsignal von einer Steuerung zur Voreinstellung der Peripherie-Einheit (1, 2) als eine Master- oder als eine Slave-Einheit zu empfangen, wobei der Sensoreingang (10) der Master-Einheit (1) niederohmig und der Sensoreingang (11) der Slave-Einheit (2) hochohmig geschaltet ist.

5. Peripherie-Einheit nach Anspruch 4, **dadurch gekennzeichnet, dass** die Umschalteinrichtung (14, 16; 15, 17) dazu ausgebildet ist, mittels eines Schalters (14, 15) einen überbrückbaren hochohmigen Widerstand (16, 17) dem Messwiderstand (13, 14) in Reihe zu schalten oder den niederohmigen Messwiderstand (13, 14) einem hochohmigen Widerstand parallelzuschalten.

## Claims

1. Arrangement with at least two peripheral units (1, 2) and with a sensor (7), wherein each of the peripheral units (1, 2) is provided with
- a connection (5, 6) for connecting the sensor (7) to a supply voltage,
- a sensor input (10, 11) for connecting the sensor (7),
- a measuring resistor (12, 13) for acquiring a sensor current that represents a signal state and
- a switchover facility (14, 16; 15, 17) which is embodied to connect the sensor input (10, 11) with low or high impedance as a function of a switchover signal or a further switchover signal,
**characterised in that**
- the peripheral units (1, 2) are connected to one another by means of a communication line (18),
- each of the peripheral units (1, 2) is embodied
- to generate the switchover signal or receive the same from the other peripheral unit (1, 2) via the communication line (18) and
- to receive the further switchover signal from a control unit for presetting the respective peripheral unit (1, 2) as a master or as a slave unit, wherein the sensor input (10) of the master unit (1) is connected with low impedance and the sensor input (11) of the slave unit (2) is connected with high impedance.

2. Arrangement according to claim 1, **characterised in that** the switchover facility (14, 16; 15, 17) is embodied, using a switch (14, 15), to connect a bridgeable high-impedance resistor (16, 17) in series with the measuring resistor (13, 14) or to connect the low-impedance measuring resistor (13, 14) in parallel with a high-impedance resistor.

3. Arrangement according to claim 1 or 2, **characterised in that** one of the peripheral units (1, 2) is connected with high impedance if the other peripheral unit (1, 2) is connected with low impedance.

4. Peripheral unit for an arrangement according to one of claims 1 to 3, with
- a connection for connecting a sensor (7) to a supply voltage,
- a sensor input (10, 11) for connecting the sensor (7),
- a measuring resistor (12, 13) for acquiring a sensor current that represents a signal state and
- a switchover facility connected in series with the measuring resistor (12, 13), which is embodied to connect the sensor input (10, 11) with low or high impedance as a function of a switchover signal or a further switchover signal,
**characterised in that**
- the peripheral unit (1, 2) has a connection (19, 20) for connection with another peripheral unit by way of a communication line (18),
- the peripheral unit (1, 2) is embodied
- to generate the switchover signal or to receive the same from the other peripheral unit (1, 2) via the communication line (18) and
- to receive the further switchover signal from a control unit for presetting the peripheral unit (1, 2) as a master or as a slave unit, wherein the sensor input (10) is connected with low impedance to the master unit (1) and the sensor input (11) is connected with high impedance to the slave unit (2).

5. Peripheral unit according to claim 4, **characterised in that** the switchover facility (14, 16; 15, 17) is embodied, by means of a switch (14, 15), to connect a bridgeable high-impedance resistor (16, 17) in series with the measuring resistor (13, 14) or to connect the low-impedance measuring resistor (13, 14) in parallel with a high-impedance resistor.

## Revendications

1. Système comprenant au moins deux unités (1, 2) périphériques et un capteur (7), chacune des unités (1, 2) périphériques étant pourvue de
- une borne (5, 6) de connexion du capteur (7) à une tension d'alimentation,
- une entrée (10, 11) de capteur pour la connexion du capteur (7),
- une résistance (12, 13) de mesure pour relever un courant du capteur représentant un état d'un signal et
- un dispositif (14, 16; 15, 17) de commutation constitué pour, en fonction d'un signal de commutation ou d'un autre signal de commutation, monter l'entrée (10, 11) du capteur à petite valeur ohmique ou à grande valeur ohmique,
**caractérisé en ce que**
- les unités (1, 2) périphériques sont reliées entre elles au moyen d'une ligne (18) de communication,
- chacune des unités périphériques est constituée pour
- produire le signal de commutation ou le recevoir de l'autre unité (1, 2) périphérique par la ligne (18) de communication et
- recevoir l'autre signal de commutation d'une commande de préréglage de l'unité (1, 2) périphérique respective comme unité-maître ou unité-esclave, l'entrée (10) du capteur de l'unité (1) maître étant montée à petite valeur ohmique et l'entrée (11) du capteur de l'unité (2) esclave à grande valeur ohmique.

2. Système suivant la revendication 1, **caractérisé en ce que** le dispositif (14, 16; 15, 17) de commutation est constitué pour monter, au moyen d'un interrupteur (14, 15), une résistance (16, 17) ohmique pouvant être shuntée en série avec la résistance (13, 14) de mesure, pour monter la résistance (13, 14) de mesure à petite valeur ohmique en parallèle avec une résistance à grande valeur ohmique.

3. Système suivant la revendication 1 ou 2, **caractérisé en ce que** l'une des unités (1, 2) périphérique est montée à grande valeur ohmique, si l'autre unité (1, 2) périphérique est montée à petite valeur ohmique.

4. Unité périphérique pour un système suivant l'une des revendications 1 à 3, comprenant
- une borne de connexion d'un capteur (7) à une tension d'alimentation,
- une entrée (10, 11) du capteur pour la connexion du capteur (7),
- une résistance (12, 13) de mesure pour relever un courant du capteur représentant un état d'un signal,
un dispositif (14, 16; 15, 17) de commutation constitué pour, en fonction d'un signal de commutation ou d'un autre signal de commutation, monter l'entrée (10, 11) du capteur à petite valeur ohmique ou à grande valeur ohmique,
**caractérisée en ce que**
- l'unité (1, 2) périphérique a une borne (19, 20) de liaison à une autre unité périphérique par une ligne (18) de communication,
- l'unité (1, 2) périphérique est constituée pour
- produire le signal de commutation ou le recevoir de l'autre unité (1, 2) périphérique par la ligne (18) de communication et
- recevoir l'autre signal de commutation d'une commande de préréglage de l'unité (1, 2) périphérique respective comme unité-maître ou unité-esclave, l'entrée (10) du capteur de l'unité (1) maître étant montée à petite valeur ohmique et l'entrée (11) du capteur de l'unité (2) esclave à grande valeur ohmique.

5. Unité périphérique suivant la revendication 4, **caractérisée en ce que** le dispositif (14, 16; 15, 17) de commutation est constitué pour monter, au moyen d'un interrupteur (14, 15), une résistance (16, 17) ohmique pouvant être shuntée en série avec la résistance (13, 14) de mesure, pour monter la résistance (13, 14) de mesure à petite valeur ohmique en parallèle avec une résistance à grande valeur ohmique.
